# EUROPEAN PATENT SPECIFICATION

(11) **EP 3 691 428 B1**
(45) Date of publication and mention of the grant of the patent: **15.03.2023**
(21) Application number: 19209831.7
(22) Date of filing: 18.11.2019
(51) Int. Cl.: H05K 7/20

(54) **INTEGRATED COOLING MOUNT**
HALTERUNG MIT INTEGRIERTER KÜHLUNG
MONTAGE DE REFROIDISSEMENT INTÉGRÉ

(30) Priority: 31.01.2019 US 201916263891
(43) Date of publication of application: 05.08.2020
(73) Proprietor: Hamilton Sundstrand Corporation, Charlotte, NC 28217-4578 (US)
(72) Inventor: TROTMAN, Alexander, Manchester, CT 06042 (US)
(74) Representative: Dehns

(56) References cited:
- WO-A1-2008/092247
- US-A1- 2005 276 017
- US-B1- 6 702 661

## Description

### BACKGROUND

Modern electronic equipment can include heat sinks within the equipment and/or on the exterior of the equipment that use convective heat transfer from the equipment to the surrounding environment as a means of thermal management. In a typical configuration, one or more circuit card assemblies (CCAs) are located within an equipment box. In some cases, natural convection is the primary means of thermal management. In other cases, forced airflow can be directed toward or near the electronic equipment to assist in thermal management. As more electronic equipment is added in a particular configuration, the thermal management system may not be capable of providing proper thermal management under all operating conditions. An aircraft is an example of in which electronic equipment can be configured to take advantage of constrained space, but this can result in a degradation of available cooling airflow to electronic equipment. Various equipment mounting configurations can also increase the complexity of trying to accommodate the thermal management requirements of a variety of electronic equipment.

An important consideration in the mechanical packaging of electronic circuitry is the ability to manage the internal temperature under all possible operating and environmental conditions. The failure to maintain CCA temperatures below component operating limits can lead to a loss of functionality of those components, and/or the shortening of their operational life. Accordingly, thermal management of electronic equipment is an important design consideration when configuring an operational asset such as an aircraft. However, existing mounting configurations for electronic equipment can result in an inadequate thermal management of that equipment under certain operating conditions. Cooling mounts are disclosed in US 6,702,661, US 2005/276017 and WO 2008/092247.

### SUMMARY

A cooling mount for supporting an electronic assembly includes a chassis having one or more air inlet ports, at least one of which is on the front, and one or more cooling fans located in the interior region. The cooling fans are configured to draw external air through the one or more air inlet ports into the interior region and to discharge air from the interior region out through the top toward the electronic assembly. The chassis width is greater than the height, and the chassis depth is also greater than the height. The cooling mount can either be attached to, or integrally formed with, the electronic assembly.

A cooling mount for supporting an electronic assembly includes a chassis having one or more air inlet ports, at least one of which is on the front, and one or more cooling fans located in apertures located in the top. The cooling fans are configured to draw external air through the one or more air inlet ports into the interior region and to discharge air from the interior region out through the top toward the electronic assembly. The chassis width is greater than the height, and the chassis depth is also greater than the height. The cooling mount can be attached to the electronic assembly.

A cooling mount for supporting an electronic assembly includes a chassis having one or more air inlet ports, at least one of which is on the front, and one or more cooling fans located in an internal region. The cooling fans are configured to draw external air through the one or more air inlet ports into the interior region and to discharge air from the interior region via a plenum and out through one or more discharge ports located on the top near the sides, thereby directing air toward external heat sinks on the electronic assembly.

### BRIEF DESCRIPTION OF THE DRAWINGS

FIG. 1A is a perspective view of a cooling mount attached to an exemplary electronic assembly.
FIG. 1B is an exploded perspective view of the cooling mount and exemplary electronic assembly of FIG. 1A.
FIG. 2A is a perspective view showing air flow through the cooling mount of FIG. 1B.
FIG. 2B is an exploded perspective view showing the cooling mount of FIG. 2A
FIG. 3A is a perspective view showing a cooling mount attached to an electronic assembly and installed in an equipment cabinet.
FIG. 3B is a perspective view showing a second embodiment of a cooling mount attached to an electronic assembly and installed in an equipment cabinet.
FIG. 3C is a perspective view showing a third embodiment of a cooling mount attached to an electronic assembly and installed in an equipment cabinet.
FIG. 3D is a perspective view showing a fourth embodiment of a cooling mount attached to an electronic assembly and installed in an equipment cabinet.
FIG. 4A is a perspective view of a fifth embodiment of a cooling mount attached to an exemplary electronic assembly.
FIG. 4B is a front cross-sectional view showing airflow through the cooling mount of FIG. 4A.

### DETAILED DESCRIPTION

An integrated cooling mount for providing improved thermal management of electronic equipment is disclosed. The integrated cooling mount can also be referred to as a modular cooling mount, or as a cooling mount. The cooling mount can be attached to, or integrated with, an electronic assembly for providing forced airflow to the circuit card assemblies (CCAs) contained within, thereby assisting in the convective cooling of those CCAs. The cooling mount can be used as a modular component in configuring the installation of new equipment, or in retrofitting an existing equipment configuration. As used in this disclosure, "thermal management" refers to the process of maintaining the temperature of CCAs within operating limits. Several factors can together provide thermal management. The present disclosure is directed to an integrated cooling mount that assists in providing airflow to an electronic equipment box to aid in thermal management.

The cooling mount can be used as a base below an equipment box, as a top above an equipment box, or on a side or face of an equipment box. Moreover, the integrated cooling mount can accommodate multiple mounting configurations including hard-mounting, rack-mounting, tray-mounting, and isolation-mounting.

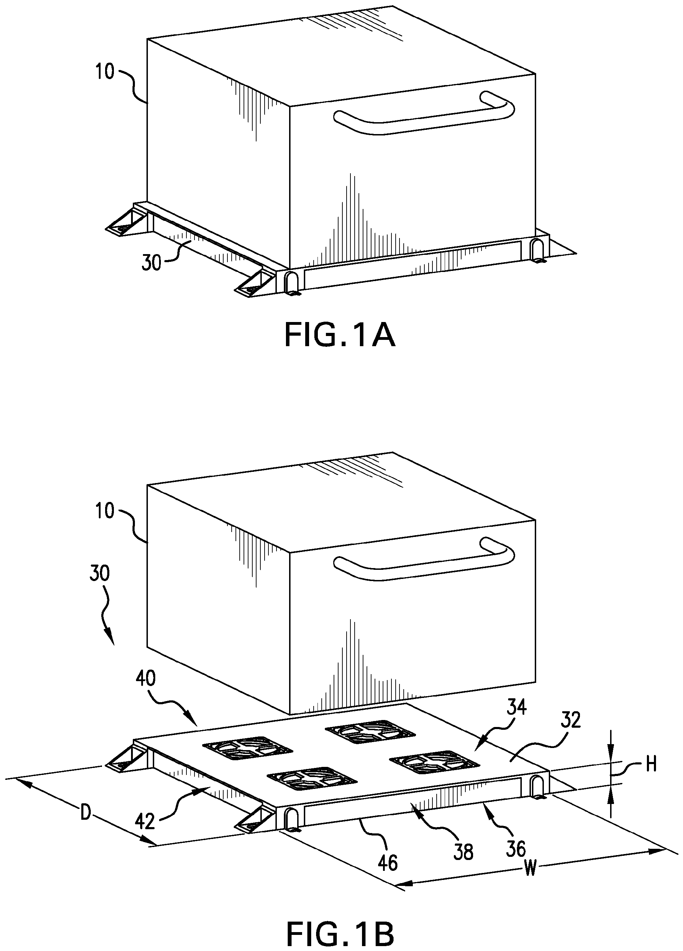

FIG. 1A is a perspective view of the cooling mount attached to an exemplary equipment box. Shown in FIG. 1A are electronic assembly 10 and cooling mount 30. Electronic assembly 10 is an exemplary equipment box that can contain one or more CCAs located within the equipment box. Electronic assembly 10 can include internal and/or external heat sinks (not shown), and can also include vents (not shown) on one or more external surfaces. Moreover, electronic assembly 10 can include one or more external panels (not shown) that can be opened and/or removed for the installation and/or maintenance of CCAs contained therein. Electronic assembly 10 can produce heat during operation of the CCAs, thereby requiring thermal management. Cooling mount 30 is used as a base below electronic assembly 10, thereby assisting in the thermal management of electronic assembly 10 and associated components.

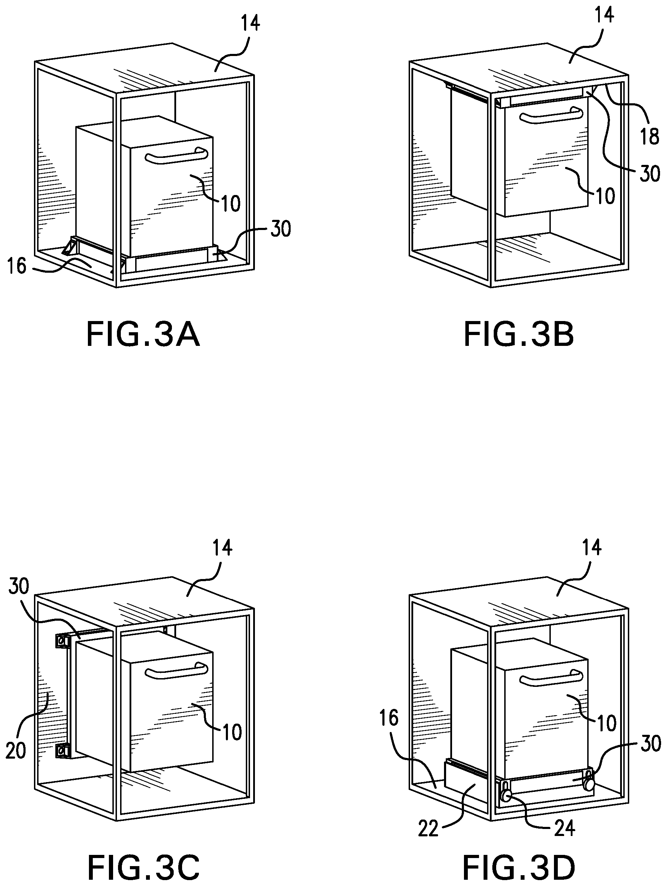

FIG. 1B is an exploded perspective view of electronic assembly 10 and cooling mount 30 of FIG. 1A. Shown in FIG. 1B are electronic assembly 10, cooling mount 30, chassis 32, top 34, bottom 36, front 38, back 40, side 42, and air inlet port 46. The dimensions of height H, width W, and depth D are also labeled. It is to be appreciated that top 34, bottom 36, front 38, back 40, and sides 42 are used to assist in identifying the location of various features of cooling mount 30 relative to each other, and are not indicative of an up/down orientation with regard to gravity. Electronic assembly 10 of the present disclosure can be used in any attitude/orientation (e.g., upright as shown, rotated sideways, up-side-down). Exemplary embodiments of electronic assembly in various attitudes/orientations will be shown later in FIGS. 3A - 3D.

In an exemplary embodiment, width W and depth D can both be approximately 6 inches (15.2 cm). In another exemplary embodiment, width W and depth D can both be approximately 12 inches (30.5 cm). In other embodiments, width W and depth D can be different from each other. For example, in an exemplary embodiment, width W can be approximately 16 inches (40.6 cm) and depth D can both be approximately 10 inches (25.4 cm). All dimensions of width W and depth D are within the scope of the present disclosure. In the illustrated embodiment, height H is less than both of width W and depth D. In some embodiments, height H is significantly less than both of width W and depth D. In an exemplary embodiment, height H can be approximately 1.5 inches (3.8 cm). In some embodiments, height H can range from approximately 1-2 inches (2.5 - 5.1 cm). In other embodiments, height H can be less than 1 inch (2.5 cm) or greater than 2 inches (5.1 cm). Generally speaking, it can be useful for height H to be less than both width W and depth D. In other words, cooling mount 30 can be said to have a low profile, thereby not contributing to the overall height envelope of electronic assembly 10 relative to width W and depth D in a particular embodiment.

Electronic assembly 10 includes chassis 32 having air inlet port 46. In the illustrated embodiment, chassis 32 is made from a metal or metal alloy. Non-limiting examples of metallic materials that can be used include nickel, aluminum, titanium, copper, iron, cobalt, silver, and all alloys that include any of these various metals. In some embodiments, various alloys of aluminum can be used to make chassis 32. In a particular embodiment, aluminum alloy 6061 can be used to make chassis 32. In the illustrated embodiment, various manufacturing methods can be used to make chassis 32, with manufacturing methods including without limitation extrusion, forging, subtractive manufacturing, casting, molding, and combinations of these methods. In other embodiments, chassis 32 can be made by additive manufacturing and/or hybrid additive subtractive manufacturing processes. In some embodiments, chassis 32 can be made from plastics, resins, ceramics, fibers, composites, and other materials. In a particular embodiment, it can be beneficial for chassis 32 to be lightweight, thereby not contributing appreciably to the overall weight of a particular equipment configuration. In another particular embodiment, it can be beneficial for chassis 32 to be relatively rigid and/or have relatively high material strength. In yet another particular embodiment, it can be beneficial for chassis 32 to be resilient and/or partially compliant, thereby providing some degree of mechanical shock absorption and/or vibration dampening. It is to be appreciated that one or more of the aforementioned properties of chassis 32 can be combined with any of these and/or with any other properties in a particular embodiment.

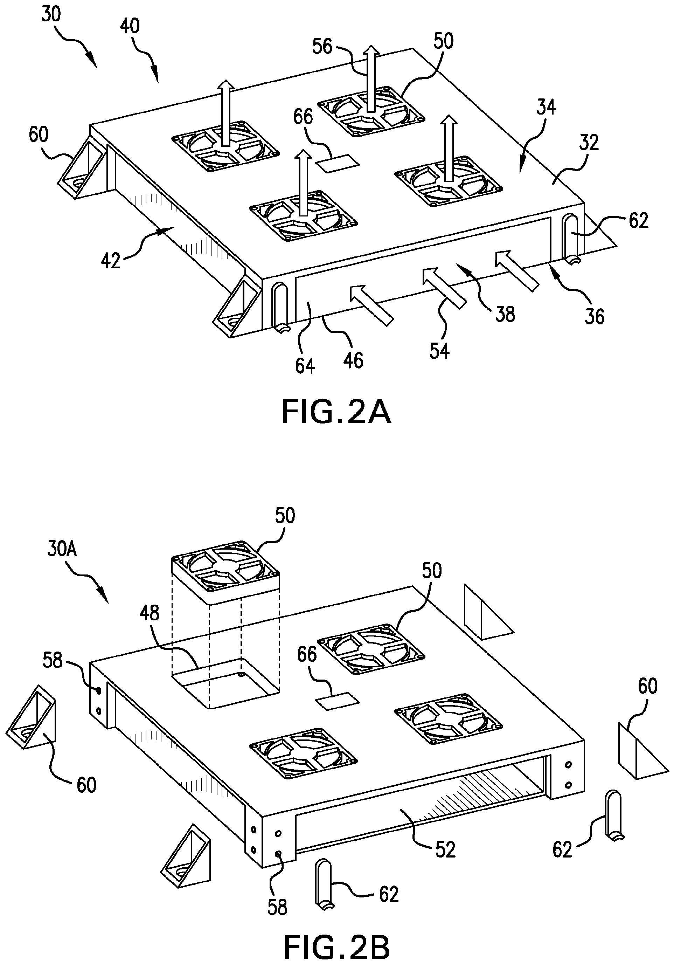

Referring again to FIG. 1B, air inlet port 46 is located on front 38 of cooling mount 30. In the illustrated embodiment, a single air inlet port 46 covers a significant portion of front 38. In some embodiments, two or more air inlet ports 46 can be located on front 38. In other embodiments, one or more air inlet ports 46 can also be located on other surfaces of cooling mount 30 (e.g., back 40 and/or one or both sides 42). It is to be appreciated that front 38 of cooling mount 30 is identified by the location of at least one air inlet port 46. As described above, other spatial features (i.e., back 40, sides 42) of cooling mount 30 are for reference purposes, and are not intended to be limiting. Additional features of cooling mount 30 will be described later in FIGS. 2A - 2B.

FIG. 2A is a perspective view showing air flow through cooling mount 30 of FIG. 1B. FIG. 2B is an exploded perspective view showing cooling mount 30 of FIG. 2A. Shown in FIGS. 2A - 2B are cooling mount 30, chassis 32, top 34, bottom 36, front 38, back 40, side 42, air inlet port 46, cooling fans 50, interior region 52, inlet air 54, discharge air 56, apertures 58, hard mounts 60, dagger mounts 62, filter 64, and connector port 66. The descriptions of cooling mount 30, chassis 32, top 34, bottom 36, front 38, back 40, side 42, and air inlet port 46 are substantially as provided earlier with regard to FIG. 1B. In the illustrated embodiment, four cooling fans 50 are arranged on top 34 of cooling mount 30, each cooling fan 50 being located in cooling fan port 48. Chassis 32 has interior region 52, in which the bodies of cooling fans 50 are located. Interior region 52 also includes a void space through which air can flow during the operation of cooling mount 30. During operation, cooling fans 50 are powered from a low-voltage power supply (not shown) and move discharge air 56 upward from top 34. As discharge air 56 is pushed upward by cooling fans 50, a negative pressure region is created within interior region 52, thereby drawing inlet air 54 into cooling mount 30 through air inlet port 46. In an exemplary embodiment, cooling fans 50 can be similar to the type used for cooling a computer case, and can be known as a "computer fan". In a particular embodiment, cooling fans 50 can be variable in speed, thereby providing a variable flowrate of discharge air 56. In some embodiments, control circuitry (not shown) can be used to turn cooling fans 50 on and off, and/or vary the speed of cooling fans 50, in response to one or more parameters (e.g., temperature). In other embodiments, cooling fans 50 can be a type of fan that is different from that described above. For example, in some of these other embodiments, cooling fans 50 can have a shape, design, or power supply requirement that is different from that described above. Four cooling fans 50 are shown in the illustrated embodiment. In other embodiments, any number of cooling fans 50 can be included with cooling mount 30. Computer fans and the like are known to those who are skilled in the electronics thermal management art. Accordingly, the associated mounting configurations and power supply connections for cooling fans 50 are not shown.

Referring again to FIGS. 2A - 2B, hard mounts 60 and dagger mounts 62 are located around the perimeter of and attached to cooling mount 30 by means of apertures 58 using threaded fasteners or other suitable mechanical attachment devices (not shown). Hard mounts 60 can be used to attach cooling mount 30 to a platform or other surface that can be used to mount (i.e., secure in position) electronic assembly 10 in a particular equipment space or equipment cabinet (not shown in FIGS. 2A - 2B). In some embodiments, hard mounts 60 can be directly attached to a surface, for example, a surface in an equipment cabinet. In other embodiments, hard mounts 60 can be attached to a surface by means of vibration mounts and the like that can be used for mechanical shock and/or vibration reduction. Dagger mounts 62 can be used for securing cooling mount 30 to a platform, equipment tray, or the like. Those who are skilled in the electronic equipment art are familiar with the use of dagger mounts which can be used, for example, with a latch mechanism (not shown in FIGS. 2A - 2B). In some embodiments, either hard mounts 60 or dagger mounts 62 can be used with cooling mount 30. In other embodiments, any number of hard mounts 60 and/or dagger mounts 62 can be used on cooling mount 30 (i.e., either greater than or fewer than the number illustrated in FIGS. 2A - 2B). In yet other embodiments, cooling mount 30 may not have any hard mounts 60 or dagger mounts 62. In some of these other embodiments, any other means, or no means at all, can be used to affix cooling mount 30 to a particular platform.

In some embodiments, cooling mount 30 can be attached to electronic assembly 10, thereby mating cooling mount 30 to electronic assembly 10. This can be referred to as being matingly attachable. In some of these embodiments, threaded fasteners (not shown) or other fasteners can be used to attach cooling mount 30 to electronic assembly 10. In other embodiments, cooling mount 30 can be integrally formed with electronic assembly 10. A non-limiting example of integrally forming cooling mount 30 with electronic assembly 10 is replacing a bottom access panel on electronic assembly 10 with cooling mount 30, thereby creating a configuration in which cooling mount 30 becomes the bottom access panel on electronic assembly 10. An integral combination of cooling mount 30 and electronic assembly 10 can be referred to as an integrated electronic assembly.

In the illustrated embodiment, filter 64 is positioned on air inlet port 46, thereby filtering inlet air 54 being drawn into cooling mount 30. Filter 64 can be useful for removing foreign material, dust, dirt, and the like from being drawn into cooling mount 30. In some embodiments, filter 64 can be a grille (i.e., grating, screen) that prevents relatively large objects from entering cooling mount 30. In these embodiments, filter 64 can also perform a safety function in preventing fingers from entering cooling mount 30, where they can come into contact with one or more cooling fans 50. In other embodiments, filter 64 can be made of a filter medium that prevents finer particles or particulates from entering cooling mount 30. In yet other embodiments, filter 64 can be a high efficiency particulate air (HEPA) filter, ultra-low particulate air (ULPA) filter, and the like. As noted above, in some embodiments more than one air inlet port 46 can be located on cooling mount 30. Accordingly, in these embodiments, filter 64 can be associated with each air inlet port 46. In some embodiments, filter 64 can be replaceable.

Referring again to FIGS. 2A - 2B, connector port 66 is located on top 34 of cooling mount 30 and can be used for providing electrical power and/or control functions to cooling fans 50. In some embodiments, cooling fans 50 can be powered from electronic assembly 10 (shown in FIGS. 1A - 1B). In other embodiments, cooling fans 50 can be powered from some other power supply (not shown). In some embodiments, connector port 66 can include control circuitry that performs monitoring and/or control functionality for cooling fans 50. In other embodiments, connector port 66 can include temperature and/or airflow monitoring devices. For example, in a particular embodiment, connector port 66 can include instrumentation (not shown) that detects the flow rate of inlet air 54 and/or discharge air 56. In another particular embodiment, connector port 66 can include instrumentation (not shown) that detects the temperature of inlet air 54 and/or discharge air 56. In yet another particular embodiment, connector port 66 can include instrumentation (not shown) that detects the temperature of the associated equipment (i.e., electronic assembly 10 as shown in FIGS. 1A - 1B). In some embodiments, connector port 66 can include instrumentation (not shown) that monitors the performance and/or lifetime of filter 64.

FIG. 3A is a perspective view showing cooling mount 30 attached to electronic assembly 10 and installed in an equipment cabinet. Shown in FIG. 3A are electronic assembly 10, cabinet 14, cabinet floor 16, and cooling mount 30. Electronic assembly 10 and cooling mount 30 are substantially as described above in regard to FIGS. 1A - 1B and 2A - 2B. Cabinet 14 is an exemplary equipment cabinet of the type that can be used to house electronic assembly 10. As shown in FIG. 3A, cabinet floor 16 describes the interior base of cabinet 14 (i.e., a floor surface on which electronic assembly 10 can be mounted). It is to be appreciated that cabinet 14 provides a structure for supporting electronic assembly 10 in an exemplary setting, but that a detailed description of cabinet 14 is not necessary in regard to the present disclosure. Accordingly, other interior features of cabinet 14 are not labeled in FIG. 3A. In the illustrated embodiment, cooling mount 30 is attached to cabinet floor 16 by means of a suitable attachment mechanism (i.e., hard mounts 60 and/or dagger mounts 62 and/or other fastening means, as described above in regard to FIGS. 2A - 2B). Notably, in the illustrated embodiment, electronic assembly 10 is supported from its bottom.

FIG. 3B is a perspective view showing a second embodiment of cooling mount 30 attached to electronic assembly 10 and installed in equipment cabinet 14. Shown in FIG. 3B are electronic assembly 10, cabinet 14, cabinet ceiling 18, and cooling mount 30. Electronic assembly 10, cabinet 14, and cooling mount 30 are substantially as described above in regard to FIGS. 1A - 1B and 2A - 2B. As shown in FIG. 3B, cabinet ceiling 18 describes the interior top of cabinet 14 (i.e., a surface on which electronic assembly 10 could be mounted). As noted above in regard to FIG. 3A, a detailed description of cabinet 14, or the other interior features, is not necessary in regard to the present disclosure. In the illustrated embodiment, cooling mount 30 is attached cabinet ceiling 18 by means of a suitable attachment mechanism (i.e., hard mounts 60 and/or dagger mounts 62 and/or other fastening means, as described above in regard to FIGS. 2A - 2B). Notably, in the illustrated embodiment, electronic assembly 10 is supported from its top.

FIG. 3C is a perspective view showing a third embodiment of cooling mount 30 attached to electronic assembly 10 and installed in equipment cabinet 14. Shown in FIG. 3B are electronic assembly 10, cabinet 14, cabinet wall 20, and cooling mount 30. Electronic assembly 10, cabinet 14, and cooling mount 30 are substantially as described above in regard to FIGS. 1A - 1B and 2A - 2B. As shown in FIG. 3C, cabinet wall 20 describes an interior vertical surface (e.g., wall, back) of cabinet 14 (i.e., a vertical surface on which electronic assembly 10 could be mounted). As noted above in regard to FIG. 3A, a detailed description of cabinet 14, or the other interior features, is not necessary in regard to the present disclosure. In the illustrated embodiment, cooling mount 30 is attached cabinet wall 20 by means of a suitable attachment mechanism (i.e., hard mounts 60 and/or dagger mounts 62 and/or other fastening means, as described above in regard to FIGS. 2A - 2B). Notably, in the illustrated embodiment, electronic assembly 10 is supported from its back.

FIG. 3D is a perspective view showing a fourth embodiment of cooling mount 30 attached to electronic assembly 10 and installed in equipment cabinet 14. Shown in FIG. 3D are electronic assembly 10, cabinet 14, cabinet floor 16, equipment tray 22, latch 24, and cooling mount 30. Electronic assembly 10, cabinet 14, and cooling mount 30 are substantially as described above in regard to FIGS. 1A - 1B, 2A - 2B, and cabinet floor 16 is substantially as described above in regard to FIG. 3A. Equipment tray 22 is attached to cabinet floor 16, and can allow an inward and outward sliding motion. For example, electronic assembly 10 can be mounted on equipment tray 22, and can be made to slide outward from cabinet 14 (e.g., for maintenance), and inward to cabinet 14 (e.g., for normal equipment operation). In the illustrated embodiment, equipment tray 22 is mounted in cabinet 14 by attachment to cabinet floor 16, and cooling mount 30 is attached to equipment tray 22. Latches 24 on equipment tray can be used to lock equipment tray 22 in place. In some embodiments, latches 24 can be configured to engage with dagger mounts 62 (as shown above in FIGS. 2A - 2B).

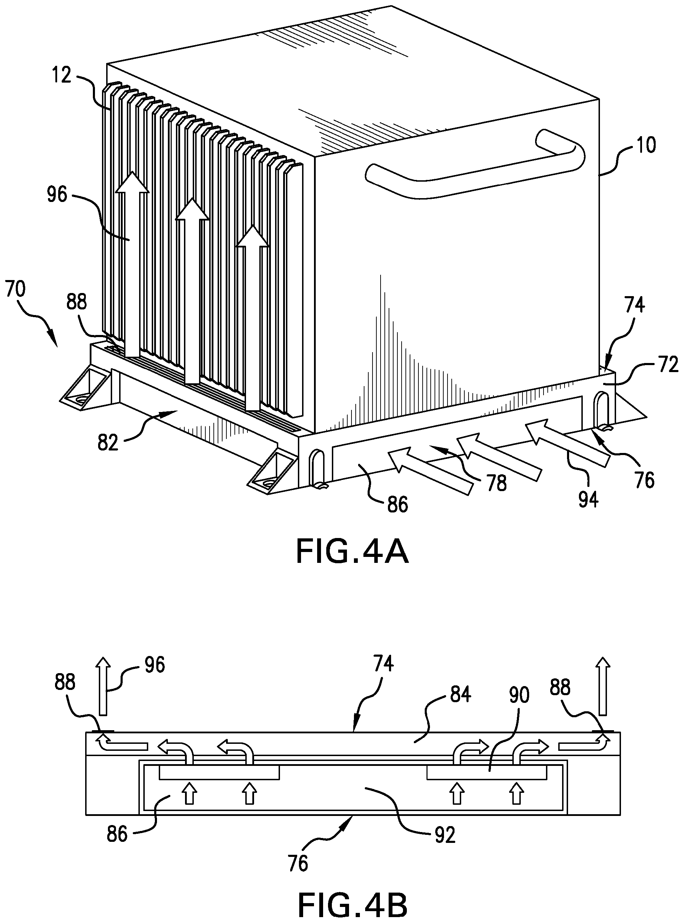

FIG. 4A is a perspective view of a fifth embodiment of the cooling mount attached to an exemplary equipment box. FIG. 4B is a front cross-sectional view showing airflow through the cooling mount of FIG. 4A. Shown in FIGS. 4A - 4B are electronic assembly 10, heat sinks 12, cooling mount 70, chassis 72, top 74, bottom 76, front 78, side 82, plenum 84, air inlet port 86, discharge port 88, cooling fans 90, interior region 92, inlet air 94, and discharge air 96. Electronic assembly 10 is substantially similar to that described above in regard to FIGS. 1A - 1B. Heat sinks 12 are located on exterior faces (i.e., sides) of electronic assembly 10 to assist in the thermal management of CCAs contained within electronic assembly 10. Chassis 72, top 74, bottom 76, front 78, side 82, plenum 84, air inlet port 86, interior region 92, and inlet air 94 are substantially similar to that described above in regard to FIGS. 2A - 2B.

In the illustrated embodiment, discharge ports 88 are located on top 74 of cooling mount 70, near sides 82, thereby directing discharge air 96 upward toward heat sinks 12 of electronic assembly 10. Cooling fans 90 are located within interior region 92 of cooling mount 70 and direct air upward into plenum 84, where it flows outward (i.e., toward sides 82) and upward through discharge ports 88. As discharge air 96 is pushed upward by cooling fans 90, a negative pressure region is created within interior region 92, thereby drawing inlet air 94 into cooling mount 70 through air inlet port 86. A filter (not shown) can be installed at air inlet port 86, as described above in regard to FIGS. 2A - 2B.

In the cross-sectional view of the illustrated embodiment, two cooling fans 90 are shown. In an embodiment, cooling mount 70 can include four cooling fans 90, as was shown in FIGS. 2A - 2B. In other embodiments, any number of cooling fans 90 can be used, and any type of cooling fans 90 can be used. In some embodiments, cooling mount 70 can include a connector port (not shown in FIGS. 4A - 4B), providing one or more functions that are substantially similar to those described above in regard to FIGS. 2A - 2B.

In the illustrated embodiment, cooling mount 70 can include hard mounts and/or dagger feet and/or other mounting mechanisms (not labeled in FIGS. 4A - 4B) that can be substantially similar to those described above in regard to FIGS. 2A - 2B.

While the invention has been described with reference to an exemplary embodiment(s), it will be understood by those skilled in the art that various changes may be made and equivalents may be substituted for elements thereof without departing from the scope of the invention as defined by the claims. In addition, many modifications may be made to adapt a particular situation or material to the teachings of the invention without departing from the scope of the claims. Therefore, it is intended that the invention not be limited to the particular embodiment(s) disclosed, but that the invention will include all embodiments falling within the scope of the appended claims.

## Claims

1. A cooling mount (30) for supporting an electronic assembly (10) in an equipment cabinet (14), the cooling mount (30) comprising:
a chassis (32) defining a top (34), bottom (36), front (38), back (40), two sides (42), a height, width, depth, and an interior region (52);
one or more air inlet ports (46), at least one of which is disposed on the front; and
one or more cooling fans (50); wherein:
the front, back, and two sides define a perimeter;
the width is greater than the height;
the depth is greater than the height; and
the cooling mount (30) is configured to be matably attached to, or integrally formed with, the electronic assembly (10);
wherein each of said cooling fans (50) is disposed in the interior region (52) and the one or more cooling fans (50) are configured to draw external air through the one or more air inlet ports (46) into the interior region (52) and to discharge air from the interior region out through the top toward the electronic assembly;
and wherein the equipment cabinet (14) defines a cabinet floor (16), a cabinet ceiling (18), and a cabinet wall; (20); and the cooling mount (30) is matably attached to the equipment cabinet (14) at a surface selected from the group consisting of: the cabinet floor (16), the cabinet ceiling (18), and the cabinet wall (20),
or wherein:
the equipment cabinet (14) defines a cabinet floor (16);
the equipment cabinet (14) further comprises an equipment tray (22) configured to slideably attach to the cabinet floor, thereby allowing the equipment tray to slide relative to the cabinet floor; and
the cooling mount (30) is matably attached to the equipment tray (22);

2. The cooling mount of claim 1, further comprising:
one or more air filters (64) disposed on at least one of the one or more air inlet ports; wherein:
each of the one or more air filters is configured to filter particulate matter, thereby preventing the particulate matter from being drawn into the interior region.

3. The cooling mount of claim 2, wherein each of the one or more air filters is a high efficiency particulate air, HEPA, filter.

4. The cooling mount of any preceding claim, further comprising:
a plurality of mounting devices; wherein:
the plurality of mounting devices are disposed on the perimeter and are configured to matably attach the cooling mount to an equipment cabinet.

5. The cooling mount of claim 4, wherein at least one of the mounting devices is a dagger mount (62), and/or wherein at least one of the mounting devices is a hard mount (60).

6. The cooling mount of any preceding claim, wherein the chassis comprises one or more of nickel, aluminum, titanium, copper, iron, cobalt, and/or alloys thereof, or wherein the chassis comprises one or more of plastic, resin, ceramic, fibers, composites, and/or combinations thereof.

7. The cooling mount of any preceding claim, further comprising a connector port (66) configured to accommodate an electrical connection to the electronic assembly.

8. The cooling mount of any preceding claim, wherein the one or more cooling fans are configured to be controllable in response to a temperature.

9. The cooling mount of any preceding claim, wherein the cooling mount is configured to provide an indication of a flow rate of the discharge air from the interior region.

10. The cooling mount of claim 2, or any claim dependent thereon, wherein the cooling mount is configured to monitor a performance level of at least one of the one or more air filters.

11. The cooling mount of any preceding claim, further comprising:
one or more cooling fan ports, at least one of which is located on the top; wherein:
a cooling fan is disposed in each of the one or more cooling fan ports.

12. The cooling mount of any preceding claim, further comprising:
one or more discharge ports (56), disposed on the top in a region near at least one of the two sides; and
a plenum (84), disposed between the interior region and the one or more discharge ports, fluidly connecting the interior region to the one or more discharge ports; wherein:
the one or more cooling fans are configured to discharge air from the interior region into the plenum, thereby directing air out through the one or more discharge ports, and preferably wherein:
the electronic assembly further comprises one or more external heat sinks (12);
the cooling mount is matably attached to the electronic assembly; and
the one or more discharge ports are configured to direct air toward the one or more external heat sinks.

## Patentansprüche

1. Kühlende Halterung (30) zum Unterstützen einer elektronischen Baugruppe (10) in einem Geräteschrank (14), wobei die kühlende Halterung (30) Folgendes umfasst:
ein Gehäuse (32), das eine Oberseite (34), eine Unterseite (36), eine Vorderseite (38), eine Rückseite (40), zwei Seiten (42), eine Höhe, Breite, Tiefe und einen Innenbereich (52) definiert; einen oder mehrere Lufteinlassanschlüsse (46), von denen mindestens einer an der Vorderseite angeordnet ist; und
einen oder mehrere Kühllüfter (50); wobei:
die Vorderseite, die Rückseite und die zwei Seiten einen Außenumfang definieren;
die Breite größer als die Höhe ist;
die Tiefe größer als die Höhe ist; und
die kühlende Halterung (30) dazu konfiguriert ist, zusammenfügbar an der elektronischen Baugruppe (10) angebracht oder einstückig mit dieser ausgebildet zu sein;
wobei jeder der Kühllüfter (50) in dem Innenbereich (52) angeordnet ist und der eine oder die mehreren Kühllüfter (50) dazu konfiguriert sind, Außenluft durch den einen oder die mehreren Lufteinlassanschlüsse (46) in den Innenbereich (52) anzusaugen und Luft aus dem Innenraum durch die Vorderseite nach außen in Richtung der elektronischen Baugruppe auszustoßen;
und wobei:
der Geräteschrank (14) einen Schrankboden (16), eine Schrankdecke (18) und eine Schrankwand (20) definiert; und
die kühlende Halterung (30) zusammenfügbar an dem Geräteschrank (14) an einer Fläche angebracht ist, die aus der Gruppe ausgewählt ist, die aus Folgenden besteht: dem Schrankboden (16), der Schrankdecke (18) und der Schrankwand (20),
oder wobei:
der Geräteschrank (14) einen Schrankboden (16) definiert;
der Geräteschrank (14) ferner ein Gerätefach (22) umfasst, das dazu konfiguriert ist, verschiebbar an dem Schrankboden angebracht zu sein, wodurch ermöglicht wird, dass das Gerätefach relativ zu dem Schrankboden gleitet; und
die kühlende Halterung (30) zusammenfügbar an dem Gerätefach (22) angebracht ist.

2. Kühlende Halterung nach Anspruch 1, ferner umfassend:
einen oder mehrere Luftfilter (64), die in mindestens einem von dem einen oder den mehreren Lufteinlassanschlüssen angeordnet sind; wobei:
jeder des einen oder der mehreren Luftfilter dazu konfiguriert ist, Feinstaub zu filtern, wodurch verhindert wird, dass der Feinstaub in den Innenbereich angesaugt wird.

3. Kühlende Halterung nach Anspruch 2, wobei jeder des einen oder der mehreren Luftfilter ein hocheffizienter Partikel-Luftfilter (high efficiency particulate air - HEPA-Filter) ist.

4. Kühlende Halterung nach einem der vorstehenden Ansprüche, ferner umfassend:
eine Vielzahl von Montagevorrichtungen; wobei:
die Vielzahl von Montagevorrichtungen auf dem Außenumfang angeordnet und dazu konfiguriert ist, die kühlende Halterung zusammenfügbar an einem Geräteschrang anzubringen.

5. Kühlende Halterung nach Anspruch 4, wobei mindestens eine der Montagevorrichtungen eine Steckhalterung (62) ist und/oder wobei mindestens eine der Montagevorrichtungen eine festmontierte Halterung (60) ist.

6. Kühlende Halterung nach einem der vorstehenden Ansprüche, wobei das Gehäuse eines oder mehrere von Nickel, Aluminium, Titan, Kupfer, Eisen, Kobalt und/oder Legierungen daraus umfasst oder wobei das Gehäuse eines oder mehrere von Kunststoff, Harz, Keramik, Fasern, Verbundstoffen und/oder Kombinationen daraus umfasst.

7. Kühlende Halterung nach einem der vorstehenden Ansprüche, ferner umfassend einen Verbinderanschluss (66), der dazu konfiguriert ist, eine elektrische Verbindung zu der elektronischen Baugruppe aufzunehmen.

8. Kühlende Halterung nach einem der vorstehenden Ansprüche, wobei der eine oder die mehreren Kühllüfter dazu konfiguriert sind, als Reaktion auf eine Temperatur steuerbar zu sein.

9. Kühlende Halterung nach einem der vorstehenden Ansprüche, wobei die kühlende Halterung dazu konfiguriert ist, eine Angabe einer Strömungsrate der Abluft aus dem Innenbereich bereitzustellen.

10. Kühlende Halterung nach Anspruch 2 oder einem davon abhängigen Anspruch, wobei die kühlende Halterung dazu konfiguriert ist, ein Leistungsniveau mindestens eines des einen oder der mehreren Luftfilter zu überwachen.

11. Kühlende Halterung nach einem der vorstehenden Ansprüche, ferner umfassend:
einen oder mehrere Kühllüfteranschlüsse, von denen sich mindestens einer an der Oberseite befindet; wobei:
ein Kühllüfter in jedem des einen oder der mehreren Kühllüfteranschlüsse angeordnet ist.

12. Kühlende Halterung nach einem der vorstehenden Ansprüche, ferner umfassend:
einen oder mehrere Ausstoßanschlüsse (56), die an der Oberseite in einem Bereich in der Nähe mindestens einer der zwei Seiten angeordnet sind; und
einen Luftraum (84), der zwischen dem Innenbereich und dem einen oder den mehreren Ausstoßanschlüssen angeordnet ist, der den Innenbereich mit dem einen oder den mehreren Ausstoßanschlüssen fluidverbindet; wobei:
der eine oder die mehreren Kühllüfter dazu konfiguriert sind, Luft aus dem Innenbereich in den Luftraum auszustoßen, wodurch Luft durch den einen oder die mehreren Ausstoßanschlüsse nach außen geleitet wird, und wobei vorzugsweise:
die elektronische Baugruppe ferner einen oder mehrere externe Kühlkörper (12) umfasst;
die kühlende Halterung zusammenfügbar an der elektronischen Baugruppe angebracht ist; und
der eine oder die mehreren Ausstoßanschlüsse dazu konfiguriert sind, Luft in Richtung des einen oder der mehreren Kühlkörper zu leiten.

## Revendications

1. Montage de refroidissement (30) pour supporter un ensemble électronique (10) dans une armoire d'équipement (14), le montage de refroidissement (30) comprenant :
un châssis (32) définissant une partie supérieure (34), une partie inférieure (36), une partie avant (38), une partie arrière (40), deux côtés (42), une hauteur, une largeur, une profondeur et une région intérieure (52) ;
un ou plusieurs orifices d'entrée d'air (46), dont au moins un est disposé à l'avant ; et
un ou plusieurs ventilateurs de refroidissement (50) ; dans lequel :
la partie avant, la partie arrière et les deux côtés définissent un périmètre ;
la largeur est supérieure à la hauteur ;
la profondeur est supérieure à la hauteur ; et
le montage de refroidissement (30) est configuré pour être fixé par emboîtement à, ou formé d'un seul tenant avec, l'ensemble électronique (10) ; dans lequel
chacun desdits ventilateurs de refroidissement (50) est disposé dans la région intérieure (52) et les un ou plusieurs ventilateurs de refroidissement (50) sont configurés pour aspirer de l'air extérieur par les un ou plusieurs orifices d'entrée d'air (46) dans la région intérieure (52) et pour évacuer l'air de la région intérieure par la partie supérieure vers l'ensemble électronique ;
et dans lequel :
l'armoire d'équipement (14) définit un plancher d'armoire (16), un plafond d'armoire (18) et une paroi d'armoire ; (20) ; et
le montage de refroidissement (30) est fixé par emboîtement à l'armoire d'équipement (14) au niveau d'une surface choisie dans le groupe constitué des éléments suivants : du plancher d'armoire (16), du plafond d'armoire (18) et de la paroi d'armoire (20),
ou dans lequel :
l'armoire d'équipement (14) définit un plancher d'armoire (16) ; l'armoire d'équipement (14) comprend en outre un plateau d'équipement (22) configuré pour se fixer de manière coulissante au plancher d'armoire, permettant ainsi au plateau d'équipement de coulisser par rapport au plancher d'armoire ; et
le montage de refroidissement (30) est fixé par emboîtement au plateau d'équipement (22).

2. Montage de refroidissement selon la revendication 1, comprenant en outre :
un ou plusieurs filtres à air (64) disposés sur au moins l'un parmi un ou plusieurs orifices d'entrée d'air ; dans lequel :
chacun des un ou plusieurs filtres à air est configuré pour filtrer de la matière particulaire, empêchant ainsi la matière particulaire d'être aspirée dans la région intérieure.

3. Montage de refroidissement selon la revendication 2, dans lequel chacun des un ou plusieurs filtres à air est un filtre à air particulaire à haute efficacité, HEPA.

4. Montage de refroidissement selon une quelconque revendication précédente, comprenant en outre :
une pluralité de dispositifs de montage ; dans lequel :
la pluralité de dispositifs de montage sont disposés sur le périmètre et sont configurés pour fixer par emboîtement le montage de refroidissement à une armoire d'équipement.

5. Montage de refroidissement selon la revendication 4, dans lequel au moins l'un parmi les dispositifs de montage est un support de poignard (62), et/ou dans lequel au moins l'un parmi les dispositifs de montage est un support rigide (60).

6. Montage de refroidissement selon une quelconque revendication précédente, dans lequel le châssis comprend un ou plusieurs éléments parmi le nickel, l'aluminium, le titane, le cuivre, le fer, le cobalt et/ou des alliages de ceux-ci, ou dans lequel le châssis comprend un ou plusieurs éléments parmi le plastique, la résine, la céramique, les fibres, les composites et/ou des combinaisons de ceux-ci.

7. Montage de refroidissement selon une quelconque revendication précédente, comprenant en outre un port de connecteur (66) configuré pour recevoir une connexion électrique dans l'ensemble électronique.

8. Montage de refroidissement selon une quelconque revendication précédente, dans lequel les un ou plusieurs ventilateurs de refroidissement sont configurés pour pouvoir être commandés en réponse à une température.

9. Montage de refroidissement selon une quelconque revendication précédente, dans lequel le montage de refroidissement est configuré pour fournir une indication d'un débit de l'air d'évacuation de la région intérieure.

10. Montage de refroidissement selon la revendication 2, ou l'une quelconque des revendications qui en dépendent, dans lequel le montage de refroidissement est configuré pour surveiller un niveau de performance d'au moins un parmi les un ou plusieurs filtres à air.

11. Montage de refroidissement selon une quelconque revendication précédente, comprenant en outre :
un ou plusieurs orifices de ventilateur de refroidissement, dont au moins un est situé sur la partie supérieure ; dans lequel :
un ventilateur de refroidissement est disposé dans chacun des un ou plusieurs orifices de ventilateur de refroidissement.

12. Montage de refroidissement selon une quelconque revendication précédente, comprenant en outre :
un ou plusieurs orifices d'évacuation (56), disposés sur la partie supérieure dans une région proche d'au moins un des deux côtés ; et
un plénum (84), disposé entre la région intérieure et les un ou plusieurs orifices d'évacuation, reliant fluidiquement la région intérieure aux un ou plusieurs orifices d'évacuation ; dans lequel :
les un ou plusieurs ventilateurs de refroidissement sont configurés pour évacuer l'air de la région intérieure dans le plénum, dirigeant ainsi l'air à travers les un ou plusieurs orifices d'évacuation, et de préférence dans lequel :
l'ensemble électronique comprend en outre un ou plusieurs dissipateurs thermiques externes (12) ;
le montage de refroidissement est fixé par emboîtement à l'ensemble électronique ; et
les un ou plusieurs orifices d'évacuation sont configurés pour diriger l'air vers les un ou plusieurs dissipateurs thermiques externes.
